# EUROPEAN PATENT APPLICATION

(11) **EP 2 644 669 A1**
(43) Date of publication of application: **02.10.2013**
(21) Application number: 13161373.9
(22) Date of filing: 27.03.2013
(51) Int. Cl.: C09J 7/00, H01L 21/683

(54) **Heat-peelable pressure-sensitive adhesive sheet**

(30) Priority: 27.03.2012 JP 2012071956
(71) Applicant: NITTO DENKO CORPORATION, Ibaraki-shi, Osaka 567-8680 (JP)
(72) Inventor: Hirayama, Takamasa, Ibaraki-shi, Osaka 567-8680 (JP); Murata Akihisa, Ibaraki-shi, Osaka 567-8680 (JP); Shimokawa, Daisuke, Ibaraki-shi, Osaka 567-8680 (JP)
(74) Representative: Grünecker, Kinkeldey, Stockmair & Schwanhäusser

(57) **Abstract**

There are provided a base material-less double-sided pressure-sensitive adhesive sheet without warping due to shrinkage of a base material after heat treatment, and having good peelability in heat peeling, and a method for manufacturing electronic parts or semiconductors by using the pressure-sensitive adhesive sheet. A heat-peelable pressure-sensitive adhesive sheet which is a base material-less double-sided pressure-sensitive adhesive sheet including a heat-expandable pressure-sensitive adhesive layer containing heat-expandable microspheres and a pressure-sensitive adhesive layer different from the heat-expandable pressure-sensitive adhesive layer and laminated thereon, wherein the pressure-sensitive adhesive layer has a higher elastic modulus than the heat-expandable pressure-sensitive adhesive layer.

## Description

### BACKGROUND OF THE INVENTION

### Field of the Invention

The present invention relates to a heat-peelable pressure-sensitive adhesive sheet whose adhesive force can be reduced by a heat treatment to thereby allow easy peeling thereof from an adherend, and which is suitable for application to processing steps for electronic parts and the like.
The present invention also relates to a heat-peelable pressure-sensitive adhesive sheet used for processing (polishing, dicing and the like) electronic parts (for example, semiconductor wafers and multilayer ceramic parts) as the industrial utilization field.

### Description of the Related Art

Heat-peelable pressure-sensitive adhesive sheets are conventionally known in which a pressure-sensitive adhesive layer containing a foaming agent is provided on a base material (Japanese Patent Publication No. 51-024534, and Japanese Patent Laid-Open Nos. 56-061468, 56-061469, 60-252681 and 2009-040930). The heat-peelable pressure-sensitive adhesive sheet is attempted to simultaneously satisfy both a pressure-sensitive adhesiveness holding power to withstand cutting processing of an adherend, and easy peeling and recovery of cut pieces formed therein. Specifically, the pressure-sensitive adhesive sheet has such a feature that whereas the pressure-sensitive adhesive sheet has a high pressure-sensitive adhesiveness when being pasted on an adherend, when cut pieces are recovered, a foamable pressure-sensitive adhesive layer containing a heat-expandable microsphere foams or expands by heating to thereby change the surface of the pressure-sensitive adhesive layer into an uneven surface and reduce the adhesive area with the adherend and to thereby reduce or vanish the pressure-sensitive adhesive force, and consequently, the cut pieces can easily be peeled. Particularly in the case where an adherend is brittle or of a thin layer, a so-called mount system is employed in which a support is pasted on an pressure-sensitive adhesive sheet on which the adherend has been pasted, and the adherend is processed (Japanese Patent Laid-Open No. 2003-292916).

However, in the conventional heat-peelable pressure-sensitive adhesive sheet used in such a mount system, for example, heat shrinkage of a heat-peelable pressure-sensitive adhesive sheet base material after an adherend has been heat treated generates a shrinkage stress to thereby cause warping on the adherend, and there arises a problem in transportability and processability in later processes in some cases. This phenomenon more remarkably occurs in the case of an adherend having a larger area. Against this problem, if an adherend and a support are pasted only by a pressure-sensitive adhesive layer without using a base material for a heat-peelable pressure-sensitive adhesive sheet, an effect is conceivably acquired in which the shrinkage stress by the heat shrinkage of the base material is reduced and the warping is prevented. However, in this case, there arises a problem that the peeling force in heat-peeling is reduced. This is conceivably caused by that when a heat-peelable pressure-sensitive adhesive sheet is heat-peeled, the peeling stress by foaming of a heat-expandable microsphere is dispersed in all directions because there is no base material confining a pressure-sensitive adhesive.

It is an object of the present invention to provide a heat-peelable pressure-sensitive adhesive sheet, which prevents warping of an adherend due to shrinkage of a base material after a heat treatment, and has good peelability in heat-peeling, and a method for manufacturing electronic parts and semiconductors using the pressure-sensitive adhesive sheet.

### SUMMARY OF THE INVENTION

As a result of exhaustive studies to solve the above-mentioned problems, the present inventors have found: a heat-peelable pressure-sensitive adhesive sheet which is a base material-less double-sided pressure-sensitive adhesive sheet having a heat-expandable pressure-sensitive adhesive layer containing a heat-expandable microsphere and a pressure-sensitive adhesive layer laminated thereon, and has such a feature that the pressure-sensitive adhesive layer of the double-sided pressure-sensitive adhesive sheet to be heat-peeled has a higher elastic modulus than the heat-expandable pressure-sensitive adhesive layer; and that the use of the sheet can simultaneously achieve both the processability and the peelability.

According to the present invention, use of a base material-less pressure-sensitive adhesive sheet having a heat-expandable pressure-sensitive adhesive layer containing a heat-expandable microsphere and a pressure-sensitive adhesive layer, having a higher elastic modulus than the heat-expandable pressure-sensitive adhesive layer, laminated thereon generates no warping on an adherend even after a heating step, and control of the direction of the foaming stress in heat-peeling can prevent the reduction in heat-peelability.

### BRIEF DESCRIPTION OF THE DRAWINGS

FIG. 1 illustrates a heat-peelable pressure-sensitive adhesive sheet according to the present invention having no elastic layer; and
FIG. 2 illustrates a heat-peelable pressure-sensitive adhesive sheet according to the present invention having an elastic layer.

### DETAILED DESCRIPTION OF THE PREFERRED EMBODIMENTS

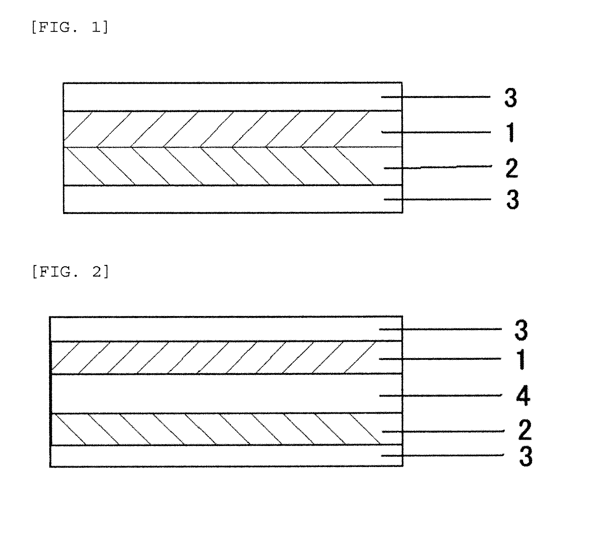

The heat-peelable pressure-sensitive adhesive sheet according to the present invention comprises two or more layers of laminated pressure-sensitive adhesives having at least one layer of a heat-expandable pressure-sensitive adhesive layer containing a heat-expandable microsphere and expanding by heating. Examples thereof are shown in FIG. 1 and FIG. 2. Reference numeral 1 represents a heat-expandable pressure-sensitive adhesive layer, and reference numeral 2 represents a pressure-sensitive adhesive layer. As required, separators 3 and an elastic layer 4 are further provided.
The heat-peelable pressure-sensitive adhesive sheet according to the present invention is a base material-less pressure-sensitive adhesive sheet, and it is one having no base material layer possibly shrinked by heat, that is, no base material without the action of pressure-sensitive adhesion and heat-expansion which is a layer for supporting a heat-expandable pressure-sensitive adhesive layer and a pressure-sensitive adhesive layer, and thus the sheet is fundamentally constituted of a laminate comprising the above-mentioned heat-expandable pressure-sensitive adhesive layer and pressure-sensitive adhesive layer. Here, a so-called release sheet is not included by the base material layer.

### (Heat-expandable pressure-sensitive adhesive layer)

A heat-expandable pressure-sensitive adhesive layer contains a heat-expandable microsphere, and expands by heating, and reduces an adhesive force to an adherend by unevenly deforming the pressure-sensitive adhesive layer of the surface thereof through uneven deformation by the expansion. Therefore, by heat treating the heat-expandable pressure-sensitive adhesive layer of the heat-peelable pressure-sensitive adhesive sheet adhered to the adherend at an optional time, the heat-peelable pressure-sensitive adhesive sheet is allowed to be peeled simply from the adherend.

The heat-expandable pressure-sensitive adhesive layer can be formed, for example, as a mixed layer of a heat-expandable microsphere and a binder. The binder usable is suitable ones, such as polymers and waxes, allowing foaming and/or expansion of the heat-expandable microsphere by heating. Above all, a binder is preferable which does not restrict foaming and/or expansion of the heat-expandable microsphere as much as possible. A binder especially preferably usable is a pressure-sensitive adhesive from the viewpoint of the controllability of the heat expandability of the heat-expandable microsphere and the pressure-sensitive adhesiveness characteristics such as the adhesive force to an adherend through a pressure-sensitive adhesive layer.

The pressure-sensitive adhesive used in the heat-expandable pressure-sensitive adhesive layer is not especially limited, but may include one or more of suitable adhesives, for example, those from polymers such as rubber-, acryl-, vinylalkyl ether-, silicone-, polyester-, polyamide-, urethane- and fluorine-based polymers and styrene-diene block copolymers, those having improved creep property by incorporation of a heat fusible resin having a melting point of about 200°C or lower, radiation-curable adhesives, and combinations thereof with various additives, for example, a crosslinking agent, a tackifier, a plasticizer, a softening agent, a filler, a pigment, a colorant, an antiaging agent and/or a surfactant, as necessary.
Examples of these pressure-sensitive adhesives include ones described in Japanese Patent Laid-Open Nos. 56-61468, 63-30205 and 63-17981 and Japanese Patent Publication No. 56-13040, and the like.

From the viewpoint of the balance between the controllability of a reasonable adhesive force before heating to an adherend through a pressure-sensitive adhesive layer and the reducibility of the adhesive force by heating, and other factors, a more preferable pressure-sensitive adhesive described above is one containing, as a base polymer, a polymer having a dynamic elastic modulus of 50,000 to 10,000,000 dyn/cm² in the temperature range of normal temperature to 150°C, but is not limited thereto.

Such a pressure-sensitive adhesive is, for example, rubber-based pressure-sensitive adhesives containing, as a base polymer, a rubber-based polymer such as natural rubbers, polyisoprene rubbers, styrene-butadiene rubbers, styrene-isoprene-styrene block copolymer rubbers, styrene-butadiene-styrene block copolymer rubbers, regenerated rubbers, butyl rubbers, polyisobutylene and NBR, and acrylic pressure-sensitive adhesives containing, as a base polymer, an acrylic polymer containing an alkyl ester of acrylic acid and/or methacrylic acid as a component.

The acrylic polymer includes one containing, for example, one or two or more esters of acrylic acid and/or methacrylic acid having a straight-chain or branched-alkyl group having 1 to 20, particularly 4 to 18, carbon atoms such as a methyl group, an ethyl group, a propyl group, a butyl group, an amyl group, a hexyl group, a heptyl group, a 2-ethylhexyl group, an isooctyl group, an isononyl group, an isodecyl group, a dodecyl group, a lauryl group, a tridecyl group, a tetradecyl group, a pentadecyl group, a hexadecyl group, a heptadecyl group, an octadecyl group, a nonadecyl group or an eicosyl group.
An acryl monomer particularly as a main component preferably used is ethyl acrylate, butyl acrylate, 2-ethylhexyl acrylate, isooctyl acrylate, isononyl acrylate, methyl methacrylate, or the like.

The acrylic polymer to be used may be a copolymer of one or more monomers suitable for improvements in the cohesive force, the heat resistance, the crosslinkability and the like. The copolymerizable monomer is not especially limited, but may be one copolymerizable with the above-mentioned acrylic acid-based alkyl ester.

Examples of the copolymerizable monomer include carboxyl group-containing monomers such as acrylic acid, methacrylic acid, carboxyethyl acrylate, carboxypentyl acrylate, itaconic acid, maleic acid, fumaric acid and crotonic acid, acid anhydride monomers such as maleic anhydride and itaconic anhydride, and hydroxyl group-containing monomers such as hydroxyethyl (meth)acrylate, hydroxypropyl (meth)acrylate, hydroxybutyl (meth)acrylate, hydroxyhexyl (meth)acrylate, hydroxyoctyl (meth)acrylate, hydroxydecyl (meth)acrylate, hydroxylauryl (meth)acrylate and (4-hydroxymethylcyclohexyl)methyl methacrylate.
A functional monomer is preferably acrylic acid or methacrylic acid, especially in view of reactivity to an epoxy crosslinking agent, or if it is for reaction with an isocyanate crosslinking agent, preferably a hydroxyl group-containing monomer; examples used as the hydroxyl group-containing monomer are 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate and (4-hydroxymethylcyclohexyl)methyl (meth)acrylate.

Examples of the copolymerizable monomer further include sulfonic acid group-containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate and (meth)acryloyloxynaphthalenesulfonic acid, phosphoric acid group-containing monomers such as 2-hydroxyethylacryloyl phosphate, (N-substituted) amide-based monomers such as (meth)acrylamide, N,N-dimethyl(meth)acrylamide, N-butyl(meth)acrylamide, N-methylol(meth)acrylamide and N-methylolpropane(meth)acrylamide, alkylamino (meth)acrylate-based monomers such as aminoethyl (meth)acrylate, N,N-dimethylaminoethyl (meth)acrylate and t-butylaminoethyl (meth)acrylate, alkoxyalkyl (meth)acrylate-based monomers such as methoxyethyl (meth)acrylate and ethoxyethyl (meth)acrylate, maleimide-based monomers such as N-cyclohexylmaleimide, N-isopropylmaleimide, N-laurylmaleimide and N-phenylmaleimide, itaconimide-based monomers such as N-methylitaconimide, N-ethylitaconimide, N-butylitaconimide, N-octylitaconimide, N-2-ethylhexylitaconimide, N-cyclohexylitaconimide and N-laurylitaconimide, and succinimide-based monomers such as N-(meth)acryloyloxymethylene succinimide, N-(meth)acryloyl-6-oxyhexamethylene succinimide and N-(meth)acryloyl-8-oxyoctamethylene succinimide.

Examples of the copolymerizable monomer further include vinylic monomers such as vinyl acetate, vinyl propionate, N-vinylpyrrolidone, methylvinylpyrrolidone, vinylpyridine, vinyl piperidone, vinylpyrimidine, vinylpiperazine, vinylpyrazine, vinylpyrrole, vinylimidazole, vinyloxazol, vinylmorpholine, N-vinylcarboxylic acid amides, styrene, α-methylstyrene and N-vinylcaprolactam, cyanoacrylate-based monomers such as acrylonitrile and methacrylonitrile, epoxy group-containing acrylic monomers such as glycidyl (meth)acrylate, glycolic acryl ester monomers such as polyethylene glycol (meth)acrylate, polypropylene glycol (meth)acrylate, methoxyethylene glycol (meth)acrylate and methoxypolypropylene glycol (meth)acrylate, acrylate esteric monomers such as tetrahydrofurfuryl (meth)acrylate, fluorine (meth)acrylate, silicone (meth)acrylate and 2-methoxyethyl acrylate, polyfunctional monomers such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylate, polyester acrylate, urethane acrylate, divinylbenzene, butyl diacrylate and hexyl diacrylate, and isoprene, butadiene, isobutylene and vinyl ether.

On the other hand, a heat-expandable microsphere blended in the heat-expandable pressure-sensitive adhesive layer includes, for example, microcapsules in which a suitable substance, such as isobutane, propane or pentane, capable of easy gasification and heat expansion, is included inside a shell composed of a shell-forming substance, for example, a heat fusible substance or a substance to be broken by heat expansion such as vinylidene chloride-acrylonitrile copolymers, polyvinyl alcohol, polyvinyl butyral, polymethyl methacrylate, polyacrylonitrile, polyvinylidene chloride and polysulfone, by a suitable method such as coacervation or interfacial polymerization.

Use of a heat-expandable microsphere can stably suppress an increase in the degree of contamination of an adherend due to heating. Use of a foaming agent or the like which has not been microcapsulated has a poor effect on suppression of an increase in the degree of contamination maybe due to cohesive fracture of a pressure-sensitive adhesive layer forming the surface. From the viewpoint of the operability of a reduction in the adhesive force by heating, particularly a stable accomplishment of a reduction in the adhesive force, preferably used is a heat-expandable microsphere exhibiting a volume expansion until bursting of 5 or more times, particularly 7 or more times, and especially 10 or more times.

The average particle diameter of a heat-expandable microsphere to be used can suitably be determined, and usually is 100 µm or smaller, particularly 80 µm or smaller, and especially 1 to 50 µm, but is not limited thereto. As the heat-expandable microsphere, commercially available ones can be used such as a microsphere (Matsumoto Microsphere F-50D, made by Matsumoto Yushi-Seiyaku Co., Ltd.).

The amount of the heat-expandable microsphere used here may suitably be determined according to the expansion ratio, reducibility in adhesive force and the like of the heat-expandable pressure-sensitive adhesive layer. In the case of the above-mentioned binder and pressure-sensitive adhesive, the heat-expandable microsphere is used usually in 1 to 150 parts by weight, particularly 10 to 130 parts by weight, and especially 25 to 100 parts by weight, with respect to 100 parts by weight of a base polymer thereof.

The formation of the heat-expandable pressure-sensitive adhesive layer can be carried out, for example, by a method in which formulation components such as a heat-expandable microsphere and a binder are mixed in a solvent, as required, and the mixture is spread by a suitable method such as coating to thereby form a sheet-like layer. The thickness of the layer can suitably be determined according to the reducibility of the adhesive force and the like.

The thickness of the heat-expandable pressure-sensitive adhesive layer is preferably 300 µm or smaller, particularly 2 to 200 µm, and more particularly 5 to 150 µm, from the viewpoint of prevention of development of an insufficient adhesive force due to unevenness, of the pressure-sensitive adhesive layer provided on the heat-expandable pressure-sensitive adhesive layer, caused by a surface unevenness based on the heat-expandable microsphere due to an excessively small thickness of the heat-expandable pressure-sensitive adhesive layer, prevention of an increase in the degree of contamination of an adherend by cohesive failure of the pressure-sensitive adhesive layer provided thereon in a heat treatment, prevention of an insufficiency in the reduction of the adhesive force based on heat deformation failure due to the excessively large thickness thereof, and other factors. The elastic modulus of a heat-expandable pressure-sensitive adhesive layer is, by the following AFM force curve method, preferably 300 MPa or lower, more preferably 100 MPa or lower, and still more preferably 50 MPa or lower.

### (Pressure-sensitive adhesive layer)

As a pressure-sensitive adhesive constituting a pressure-sensitive adhesive layer 2, the pressure-sensitive adhesive used for the heat-expandable pressure-sensitive adhesive layer can be employed. Alternatively, an energy ray-curable pressure-sensitive adhesive or a thermosetting pressure-sensitive adhesive may be used. As these pressure-sensitive adhesives, agents can be used in which an energy ray-curable compound (or an energy ray-curable resin) or a thermopolymerizable compound is blended in a base agent having pressure-sensitive adhesiveness. Alternatively, agents may be used in which a base agent having pressure-sensitive adhesiveness is chemically modified with an energy ray-reactive functional group such as a carbon-carbon double bond.
The thickness of the pressure-sensitive adhesive layer 2 is preferably 10 to 150 µm, but more preferably 10 to 100 µm, and still more preferably 20 to 60 µm.

### (Elastic modulus)

Although there are various methods for measurement of the elastic modulus of a heat-expandable pressure-sensitive adhesive layer and a pressure-sensitive adhesive layer, by using an AFM force curve method, the elastic modulus of a layered pressure-sensitive adhesive layer can be measured. The AFM force curve method involves pressing a fine indenter into a sample and calculating an elastic modulus from an unloading curve acquired from the displacement and the stress at this time.

Although the elastic modulus of the pressure-sensitive adhesive layer 2 is preferably higher than the elastic modulus of the heat-expandable pressure-sensitive adhesive layer, since too high an elastic modulus thereof may cause warping by the heat shrinkage of the pressure-sensitive adhesive layer 2, the elastic modulus as measured by the above-mentioned AFM force curve method is preferably 500 MPa or lower, more preferably 300 MPa or lower, and still more preferably 100 MPa or lower.
Additionally, the elastic modulus of the pressure-sensitive adhesive layer is higher preferably by 0.3 to 500 MPa, more preferably by 10 to 400 MPa, and still more preferably by 50 to 350 MPa, than that of the heat-expandable pressure-sensitive adhesive layer.
The elastic modulus of a pressure-sensitive adhesive layer is made to be higher than that of a heat-expandable pressure-sensitive adhesive layer, and the heat-expandable pressure-sensitive adhesive layer and the pressure-sensitive adhesive layer are superposed and pasted in order on the surface of an adherend such as a wafer or a film, and then, the adherend is subjected to a processing or the like. In the case where the adherend is peeled from the heat-expandable pressure-sensitive adhesive layer after the processing, the heat-expandable pressure-sensitive adhesive layer is heat-expanded by heating. The volume of the heat-expandable pressure-sensitive adhesive layer increases in the heat-expansion, and the increment thereof becomes a pressing force toward the pressure-sensitive adhesive layer and the adherend. At this time, since the elastic modulus of the pressure-sensitive adhesive layer is higher than that of the heat-expandable pressure-sensitive adhesive layer, the pressing force is controlled so as to be directed exclusively toward the adherend.
Therefore, the adherend can be moved without generating warping and the like so as to be lifted up from the pressure-sensitive adhesive layer to peel it from the heat-expandable pressure-sensitive adhesive layer.

The above-mentioned radiation-curable pressure-sensitive adhesive is one designed to be crosslinkingly cured by radiation irradiation, for example, in which a pressure-sensitive adhesive containing as a component a polymer produced by copolymerizing monomers having a crosslinkable functional group such as polyfunctional monomers, a pressure-sensitive adhesive prepared by blending a crosslinkable low-molecular weight compound such as polyfunctional monomers, or another pressure-sensitive adhesive is blended with a photopolymerization initiator; contaminating substances to an adherend are designed to be reduced by the crosslinking curing, and the adhesive force is also designed to be reduced according to needs.

The photopolymerization initiator blended in a radiation-curable pressure-sensitive adhesive may be, for example, acetophenone-based initiators such as 4-(2-hydroxyethoxy)phenyl (2-hydroxy-2-propyl) ketone, α-hydroxy-α,α'-dimethylacetophenone, methoxyacetophenone, 2,2-dimethoxy-2-phenylacetophenone, 2,2-diethoxyacetophenone, 1-hydroxycyclohexyl phenyl ketone and 2-methyl-1-[4-(methylthio)-phenyl]-2-morpholinopropane-1, benzoin etheric initiators such as benzoin ethyl ether, benzoin isopropyl ether and anisoin methyl ether, α-ketolic compounds such as 2-methyl-2-hydroxypropiophenone, ketalic compounds such as benzyl dimethyl ketal, aromatic sulfonyl chloride-based compounds such as 2-naphthalenesulfonyl chloride, photoactive oxime-based compounds such as 1-phenone-1,1-propanedione-2-(o-ethoxycarbonyl) oxime, benzophenone-based compounds such as benzophenone, benzoylbenzoic acid and 3,3'-dimethyl-4-methoxybenzophenone, thioxanthone-based compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone and 2,4-diisopropylthioxanthone, and besides, suitable radiation-curable types using camphor quinone, halogenated ketones, acylphosphine oxide, acyl phosphonate and the like.

A pressure-sensitive adhesive to be used in the formation of the pressure-sensitive adhesive layer may contain suitable additives blended therein such as plasticizers, fillers, surfactants, antiaging agents and tackifiers as described above, but in the applications in which the transfer of such additives to an adherend poses a problem as in the case where low contamination is desired as described above, a pressure-sensitive adhesive in which no additive is blended may be used.

The formation of a pressure-sensitive adhesive layer can be carried out by a suitable method such as a method in which a liquid pressure-sensitive adhesive is applied on a heat-expandable pressure-sensitive adhesive layer, and a method in which a pressure-sensitive adhesive layer similarly formed on a separator is transferred on a heat-expandable pressure-sensitive adhesive layer. The thickness of a pressure-sensitive adhesive layer can suitably be determined according to the use purpose of a pressure-sensitive adhesive sheet, the reducibility of the adhesive force by heating, and the like. On surfaces of a heat-expandable pressure-sensitive adhesive layer and a pressure-sensitive adhesive layer different from the heat-expandable pressure-sensitive adhesive layer in the present invention, a release sheet (separator) or the like can be laminated in order to protect these layers.

### (Separator)

The separator can be provided, for example, as a plastic film or sheet, such as of polyester, olefinic resin or polyvinyl chloride, surface-treated with a suitable release agent such as a silicone-based one, a long chain alkyl-based one, a fluorine-based one or molybdenum sulfide, as a low-adhesive base material composed of a fluorine-based polymer such as polytetrafluoroethylene, polychlorotrifluoroethylene, polyvinyl fluoride, polyvinylidene fluoride, a tetrafluoroethylene-hexafluoropropylene copolymer or a chlorotrifluoroethylene-vinylidene fluoride copolymer, or as a low-adhesive base material composed of a nonpolar polymer such as polyethylene, polypropylene or α-olefin.

### (Elastic layer)

An elastic layer is formed of a synthetic rubber or a synthetic resin, or may be formed of a pressure-sensitive adhesive forming the above-mentioned pressure-sensitive adhesive layer, or may be formed of a porous film such as a foaming film containing such a component as a main component. The formation of an elastic layer can be carried out by a suitable method such as a method in which a solution of the above forming agent is applied on a base material, and a method in which a film or the like composed of the forming agent is adhered with a base material; and an arrangement form of an elastic layer is preferably such that the elastic layer is superposed on a side of a heat-expandable pressure-sensitive adhesive layer opposite to a side thereof provided with a pressure-sensitive adhesive layer, from the viewpoint of the above-mentioned action and the like. In the case where a pressure-sensitive adhesive layer is treated with radiation or the like, the elastic layer is made to be an intermediate layer capable of transmitting the treating rays.
The synthetic rubber or the synthetic resin includes, for example, synthetic rubbers such as nitrile-based, dienic or acrylic ones, thermoplastic elastomers such as polyolefinic or polyesteric ones, and synthetic resins having rubber elasticity such as ethylene-vinyl acetate copolymers, polyurethane, polybutadiene and soft polyvinyl chloride. Polymers, which would be intrinsically hard polymers like polyvinyl chloride, imparted with rubber elasticity by combination with blending agents such as a plasticizer and a softening agent can be used in the present invention.

The elastic layer is not a layer to function as a so-called base material to support the heat-expandable pressure-sensitive adhesive layer and the pressure-sensitive adhesive layer different from the heat-expandable pressure-sensitive adhesive layer, but a layer to impart a higher elasticity to the heat-peelable pressure-sensitive adhesive sheet according to the present invention, in order for an adherend not to generate warping after a heating step. The thickness of an elastic layer is in the range of exhibiting such a degree of a property that the elastic layer does not substantially become a base material layer, in consideration of the elastic modulus and the thickness. The thickness is, though depending on the elastic modulus, 1 µm to 50 µm, preferably 3 to 20 µm, and more preferably 5 to 10 µm.

### (Applications and use methods)

The heat-peelable pressure-sensitive adhesive sheet according to the present invention can be used in various types of applications by forming it into a suitable form such as a sheet-shape, a tape-shape or a label-shape, and using it for adhesion of adherends, similarly to conventional pressure-sensitive adhesive sheets, but the heat-peelable pressure-sensitive adhesive sheet can be used preferably in applications requiring or desiring the release of an adherend from the adhesion state, after the adherend has been adhered for a predetermined period, by making the best use of the feature of the heat-peelable pressure-sensitive adhesive sheet, which can easily be peeled from the adherend by reducing the adhesive force by a heat treatment in an optional period. An adherend is not especially limited, but may be ones composed of an optional material, for example, a metal, a ceramic, a plastic, wood or paper, and the adhesion surface may have an optional shape such as a plate-shape, a curved surface-shape and a fibrous shape.

Example of the applications include formation of adhesion composites from articles composed of two or more component articles, for example, a polymeric article and a metallic article, fibers or paper to recycle them; carrier tapes, temporary fixation materials, or fixation materials for transport and temporary fixation of parts in assembling steps for various types of electric devices, electronic devices, displays or the like; and surface protection materials and masking materials for prevention of contamination and damage of metal plates, plastic plates, glass plates or the like.

Particularly the heat-peelable pressure-sensitive adhesive sheet according to the present invention can be used preferably in applications, such as a back surface polishing treatment and a dicing treatment of a semiconductor wafer, desiring that the heat-peelable pressure-sensitive adhesive sheet can be adhered to an adherend by a strong adhesive force in processing, and when the adhesion state is released, there remains little contamination on the adherend, because the present invention can suitably set the pressure-sensitive adhesiveness characteristics such as the adhesive force through a pressure-sensitive adhesive layer according to the use purpose, and contaminating substances, particularly micro contaminating substances, accompanying the reduction treatment of the adhesive force by heating, increase little.

A heat treatment to reduce the adhesive force of a heat-peelable pressure-sensitive adhesive sheet described above can be carried out using a suitable heating means such as a hot plate, a hot air drier or a near infrared lamp. The condition of the heat treatment can be determined suitably according to conditions including the reducibility of an adhesive area depending on the surface state of an adherend and the kind of a heat-expandable microsphere, the heat resistance and the heat capacity of a base material and the adherend, and the heating means.

The heat treatment is usually carried out at a temperature of 100 to 250°C for 5 to 90 sec (hot plate or the like) or for 1 to 15 min (hot air drier or the like), but is not limited thereto. A heat treatment according to the above-mentioned condition usually expands and/or foams the heat-expandable microsphere and unevenly deforms the heat-expandable pressure-sensitive adhesive layer, and following this, also the pressure-sensitive adhesive layer unevenly deforms and the adhesive force reduces or vanishes.

### Examples

Hereinafter, the present invention will be described in more detail by way of Examples, but the present invention is not limited to the Examples.

### [Example 1]

A mixed liquid 1 in which 100 parts by weight of a butyl acrylate-acrylic acid (95 parts by weight : 5 parts by weight) copolymer and 3 parts by weight of a crosslinking agent (trade name: "Tetrad C", made by Mitsubishi Gas Chemical Co., Inc.) were blended was prepared. The mixed liquid 1 was applied on a polyester film of 50 µm in thickness treated with a silicone so that the thickness after drying was 30 µm, and dried to thereby form a pressure-sensitive adhesive layer 1. The elastic modulus acquired by measuring the pressure-sensitive adhesive surface with an AFM force curve (made by Asylum Technology Co., Ltd., use of an Si probe (R: 10 nm, spring constant: 1.6 nN/nm), probe travel speed: 4 µm/sec, measurement temperature: 23°C) was 3.2 MPa.
A mixed liquid 2 was prepared which was a toluene solution in which 100 parts by weight of a 2-ethylhexyl acrylate-ethyl acrylate-methyl methacrylate-2-hydroxyethyl acrylate (30 parts by weight : 70 parts by weight : 5 parts by weight : 2 parts by weight) copolymer-based pressure-sensitive adhesive, 2 parts by weight of a crosslinking agent (trade name: "Coronate L", made by Nippon Polyurethane Industry Co., Ltd.), and 30 parts by weight of a heat-expandable microsphere A (Matsumoto Microsphere F-100D, made by Matsumoto Yushi-Seiyaku Co., Ltd.) were blended.
The mixed liquid 2 was applied on a polyester film of 50 µm in thickness treated with a silicone so that the thickness after drying was 45 µm, and dried to thereby form a heat-expandable pressure-sensitive adhesive layer 2. The elastic modulus acquired by measuring the heat-expandable pressure-sensitive adhesive layer 2 by using the AFM force curve was 1.8 MPa. The obtained heat-expandable pressure-sensitive adhesive layer 2 was pasted on the pressure-sensitive adhesive layer 1 to thereby obtain a heat-peelable pressure-sensitive adhesive sheet A.

### [Example 2]

A mixed liquid 3 was prepared in which 100 parts by weight of an ultraviolet-reactive polymer (weight-average molecular weight: 500,000) obtained by adding methacryloyloxyethylene isocyanate of 0.9 equivalent weight of a hydroxyl group of a hydroxyl group-containing acrylic polymer to the acrylic polymer, 3 parts by weight of a photoreaction initiator, and 0.2 part by weight of a crosslinking agent (trade name: "Coronate L", made by Nippon Polyurethane Industry Co., Ltd.) were blended. The mixed liquid 3 was applied on a polyester film of 50 µm in thickness treated with a silicone so that the thickness after drying was 50 µm, and dried to thereby form an ultraviolet-curable pressure-sensitive adhesive layer 3. The elastic modulus before curing of the ultraviolet-curable pressure-sensitive adhesive layer 3 was 0.7 MPa, and the elastic modulus after curing by irradiation with ultraviolet rays of 300 mJ/cm² was 142 MPa. The ultraviolet-curable pressure-sensitive adhesive layer 3 was pasted on the heat-expandable pressure-sensitive adhesive layer 2 described in Example 1 to thereby obtain a heat-peelable pressure-sensitive adhesive sheet B.

### [Comparative Example 1]

The mixed liquid 1 was applied on a polyester film of 75 µm in thickness so that the thickness after drying was 50 µm, and dried, and the mixed liquid 2 was applied on the opposite side of the polyester film so that the thickness after drying was 45 µm, and dried to thereby obtain a heat-peelable pressure-sensitive adhesive sheet C.

### [Comparative Example 2]

A pressure-sensitive adhesive sheet D was obtained by the same procedure as in Example 1, except for using a mixed liquid in which 100 parts by weight of a 2-ethylhexyl acrylate-acrylic acid (97 parts by weight : 3 parts by weight) copolymer, and 2 parts by weight of a crosslinking agent (trade name: "Coronate L", made by Nippon Polyurethane Industry Co., Ltd.) were blended, for a pressure-sensitive adhesive layer. The elastic modulus of the pressure-sensitive adhesive layer was 0.8 MPa.

### [Evaluation experiments]

### Warping level

A polyimide film (230 mm square) of 50 µm in thickness was pasted on the heat-expandable pressure-sensitive adhesive layer of each pressure-sensitive adhesive sheet fabricated in the Examples and the Comparative Examples, and thereafter, the pressure-sensitive adhesive layer side was pasted on a glass plate (230 mm square) of 650 µm in thickness. Thereafter, the resultant glass plate was heated at 100°C for 1 hour using a hot air drier, and then allowed to cool to room temperature, and then, the warping level was measured.

### Heat peelability

The heat-expandable pressure-sensitive adhesive layer of each pressure-sensitive adhesive sheet fabricated in the Examples and the Comparative Examples was pasted on a SUS304BA plate, and thereafter, the pressure-sensitive adhesive layer side was pasted on a glass plate of 650 µm, heated for 12 hours in a hot air drier at 80°C, and then allowed to cool to room temperature. The pasted sample was heated on a hot plate heated at 180°C, and the peelability from the SUS plate was evaluated.

### Evaluation results

**[Table 1]**

| | Warping Level [mm] | Heat Peelability |
|---|---|---|
| Example 1 | 0 mm | ○ |
| Example 2 | 0 mm | ○ |
| Comparative Example 1 | 3 mm | ○ |
| Comparative Example 2 | 0 mm | × |

## Claims

1. A heat-peelable pressure-sensitive adhesive sheet, wherein the heat-peelable pressure-sensitive adhesive sheet is a base material-less double-sided pressure-sensitive adhesive sheet comprising: a heat-expandable pressure-sensitive adhesive layer containing heat-expandable microspheres; and a pressure-sensitive adhesive layer different from the heat-expandable pressure-sensitive adhesive layer and laminated thereon, wherein the pressure-sensitive adhesive layer has a higher elastic modulus than the heat-expandable pressure-sensitive adhesive layer.

2. The heat-peelable pressure-sensitive adhesive sheet according to claim 1, wherein the pressure-sensitive adhesive layer has an elastic modulus of 500 MPa or lower.

3. The heat-peelable pressure-sensitive adhesive sheet according to claim 1 or 2, wherein the pressure-sensitive adhesive layer comprises an energy ray-curable pressure-sensitive adhesive.

4. The heat-peelable pressure-sensitive adhesive sheet according to claim 1 or 2, wherein the pressure-sensitive adhesive layer comprises a thermosetting pressure-sensitive adhesive.

5. The heat-peelable pressure-sensitive adhesive sheet according to any one of claims 1 to 4, wherein an elastic layer is provided between the pressure-sensitive adhesive layer and the heat-expandable pressure-sensitive adhesive layer.

6. A method for manufacturing an electronic part or a semiconductor part, comprising using the heat-peelable pressure-sensitive adhesive sheet according to any one of claims 1 to 5 to process the part.
